# FASCICULE DE BREVET EUROPEEN

(11) **EP 2 960 938 B1**
(45) Date de publication et mention de la délivrance du brevet: **31.03.2021**
(21) Numéro de dépôt: 15172650.2
(22) Date de dépôt: 18.06.2015
(51) Int. Cl.: H01L 27/07, H01L 29/87, H01L 29/732

(54) **COMPOSANT DE PROTECTION CONTRE DES SURTENSIONS**
SCHUTZKOMPONENTE GEGEN ÜBERSPANNUNGEN
COMPONENT FOR PROTECTION AGAINST OVERVOLTAGES

(30) Priorité: 26.06.2014 FR 1455999
(43) Date de publication de la demande: 30.12.2015
(73) Titulaire: STMicroelectronics (Tours) SAS, 37100 Tours (FR)
(72) Inventeur: Rouviere, Mathieu, 37380 Crotelles (FR); Moindron, Laurent, 37390 Vernou Sur Brenne (FR); Ballon, Christian, 37000 Tours (FR)
(74) Mandataire: Cabinet Beaumont

(56) Documents cités:
- EP-A1- 0 677 874
- EP-A1- 0 742 591
- EP-A1- 1 098 355
- EP-A2- 0 827 204
- US-A1- 2012 161 200
- US-A1- 2012 267 679

## Description

### Domaine

La présente demande concerne un composant de protection contre des surtensions.

### Exposé de l'art antérieur

Un composant de protection contre des surtensions est un composant qui devient passant quand la tension à ses bornes dépasse un certain seuil, appelé tension de claquage couramment désignée par l'abréviation V_{BR}. Un composant de protection est par exemple du type à retournement.

Un inconvénient des composants de protection à retournement est qu'ils ne se rebloquent que si la tension à leurs bornes est telle que le courant qui les traverse devient inférieur à un courant de maintien Iₕ. On a donc proposé un dispositif permettant de rebloquer de tels composants en les court-circuitant dès la fin d'une surtension. Un tel dispositif de protection est décrit dans la demande de brevet français déposée sous le numéro 13/52864 (B12542) le 29 mars 2013 et publiée sous le numéro FR3004019.

La demande de brevet EP1098355 de la demanderesse décrit un détecteur d'état d'un composant de puissance pour indiquer si ce composant de puissance est passant ou bloqué. Le détecteur, sous forme d'un transistor vertical dont le substrat forme la base, et le composant de puissance sont formés dans le même substrat et sont séparés par un mur vertical.

### Résumé

Ainsi, il est proposé un composant selon la revendication indépendante 1.

Selon un mode de réalisation, le composant comporte en outre un deuxième transistor de même structure que le premier transistor.

Selon un mode de réalisation, le premier transistor est situé dans un coin de la puce contenant la diode de Shockley.

Un autre mode de réalisation prévoit un système de protection comportant un composant tel que ci-dessus, un commutateur connecté en parallèle de la diode de Shockley, une résistance dont une première borne est connectée à la borne principale supérieure du premier transistor, et une source de tension connectée à la deuxième borne de ladite résistance, la borne principale supérieure du premier transistor étant connectée à un circuit de détection et de commande du commutateur.

Selon un mode de réalisation, le commutateur est commandé à la fermeture et à l'ouverture en fonction de la tension entre la borne principale supérieure du premier transistor et la troisième région.

Selon un mode de réalisation, le système comprend en outre un deuxième transistor de même structure que le premier transistor, et une deuxième résistance dont une première borne est connectée à la borne principale supérieure du deuxième transistor, et dont la deuxième borne est connectée à la source de tension, la borne principale supérieure du deuxième transistor étant connectée au circuit de détection et de commande du commutateur.

Selon un mode de réalisation, le commutateur est commandé à la fermeture en fonction de la première tension entre la borne principale supérieure du premier transistor et la troisième région, et le commutateur est commandé à l'ouverture en fonction de la deuxième tension entre la borne principale supérieure du deuxième transistor et la troisième région.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 représente un exemple d'une ligne d'alimentation, reliant une source à une charge, protégée par un dispositif de protection tel que celui décrit dans la demande de brevet français FR3004019 ;
la figure 2 est une vue en coupe représentant un mode de réalisation d'un composant de protection contre des surtensions et son schéma électrique ;
la figure 3 est une vue de dessus du composant représenté en vue en coupe en figure 2 ;
la figure 4 est un schéma électrique d'un mode de réalisation d'un dispositif de protection ;
la figure 5 est un chronogramme représentant des courants et des tensions dans le dispositif de protection contre des surtensions de la figure 4 pendant une surtension ;
la figure 6 est un schéma électrique d'une variante de réalisation d'un composant de protection contre des surtensions ;
la figure 7 est un chronogramme représentant des courants et des tensions dans le dispositif de protection contre des surtensions de la figure 6 à la fin d'une surtension ; et
la figure 8 est une vue en coupe d'un exemple de réalisation pratique d'un composant illustré de façon simplifiée en figure 2 et 3.

Par souci de clarté, de mêmes éléments ont été désignés par de mêmes références aux différentes figures et, de plus, comme cela est habituel dans la représentation des circuits intégrés, les diverses figures ne sont pas tracées à l'échelle.

### Description détaillée

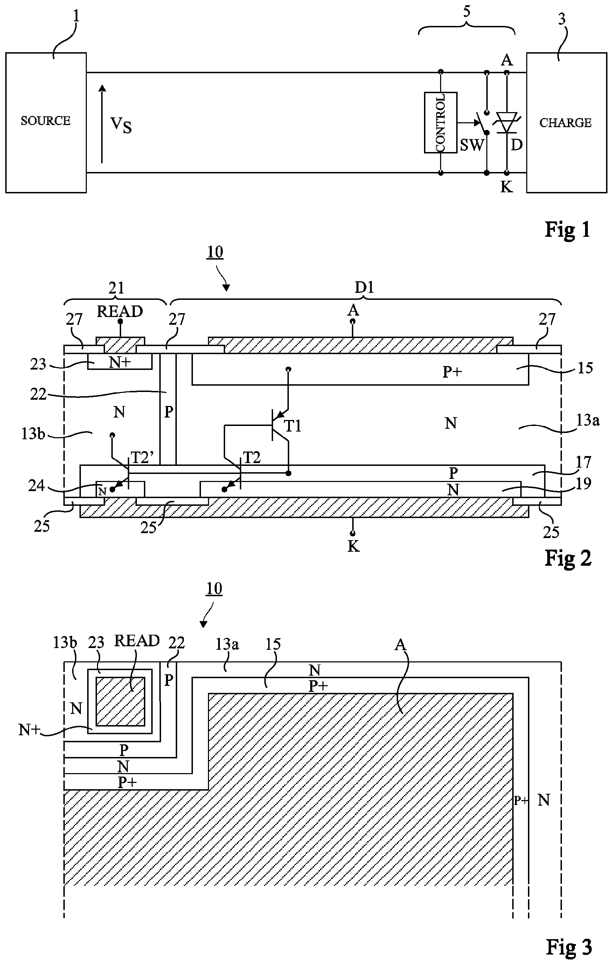

La figure 1 représente un exemple d'une ligne d'alimentation, reliant une source 1 à une charge 3, protégée par un dispositif de protection 5 tel que celui décrit dans la demande de brevet susmentionnée. La source impose une tension V_{S} aux bornes de la ligne. Le dispositif 5 est placé au plus près de la charge afin de la protéger au mieux de surtensions pouvant survenir sur la ligne par exemple par suite de coups de foudre.

Le dispositif de protection 5 comprend entre deux bornes A et K le montage en parallèle :
- d'une diode de protection de type à retournement D,
- d'un commutateur SW, et
- d'un circuit de commande (CONTROL) du commutateur SW.

Le fonctionnement du dispositif de protection de la figure 1 est le suivant.

La diode de protection a une tension de claquage supérieure à la tension V_{S}. En l'absence de surtension, la diode est non passante. Le commutateur SW est alors ouvert. Quand une surtension apparaît, la diode de protection devient passante. Une fois la surtension passée, la source 1 impose dans la diode D un courant supérieur au courant de maintien Iₕ. Le commutateur SW est alors rendu passant ce qui dérive le courant passant dans la diode D dans le commutateur SW. Il en résulte normalement que le courant dans la diode D devient inférieur au courant de maintien Iₕ et, quand le commutateur SW est réouvert, la diode est rebloquée.

La demande de brevet susmentionnée propose de commander le commutateur SW à la fermeture lorsque la tension V_{AK} aux bornes de la diode devient inférieure à une première tension de seuil et de commander le commutateur SW à l'ouverture lorsque la tension V_{AK} devient inférieure à une deuxième tension de seuil.

La première tension de seuil correspond à une valeur supérieure à la tension imposée par la source 1 aux bornes de la diode quand cette diode est passante.

La deuxième tension de seuil est inférieure à la tension existante aux bornes de la diode quand elle est parcourue par un courant égal au courant de maintien Ih.

De plus, il a été observé expérimentalement que vers la fin du pic de surtension, le courant dans la diode ne suit pas la tension VAK mais a tendance à présenter un pic secondaire. Ainsi, si la fermeture du commutateur SW est effectuée en fonction de la tension VAK, le courant dans ce commutateur tendra à commencer par augmenter, ce qui risque d'endommager ce commutateur.

Il serait donc préférable de commander le commutateur SW à la fermeture en se référant au courant réel dans la diode D de façon à fermer le commutateur lorsque le courant dans la diode est effectivement en phase de décroissance.

Il serait souhaitable d'ouvrir le commutateur SW aussi vite que possible après sa fermeture. Des expériences menées par les inventeurs ont montré que si on ouvrait le commutateur SW dans les conditions indiquées ci-dessus (ouverture dès que la tension VAK atteint une valeur inférieure à celle correspondant au passage du courant Ih dans la diode), la diode ne se rebloquait pas toujours. Les inventeurs ont analysé les causes de cette défaillance et l'attribuent au fait que, lors de la fermeture du commutateur SW, des parasites hautes fréquences apparaissent sur la tension V_{AK}. Ainsi, en commandant le commutateur SW à l'ouverture en fonction de la tension V_{AK}, le commutateur SW risque d'être commandé à l'ouverture lors d'un creux de tension alors que le courant dans la diode D est encore supérieur au courant de maintien Ih.

La figure 2 est une vue en coupe représentant un mode de réalisation d'un composant 10 de protection contre des surtensions et son schéma électrique.

La partie droite de la figure 2 représente une diode de Shockley verticale PNPN simplifiée D1 comprenant :
- une portion 13a d'un substrat semiconducteur de type N,
- du côté de la face supérieure de la portion 13a, une région 15 de type P, correspondant à l'anode de la diode, ne touchant pas les bords gauche et droit de la portion 13a,
- du côté de la face inférieure de la portion 13a, une région 17 de type P ne touchant pas le bord droit de la portion 13a,
- dans la région 17, une région 19 de type N, correspondant à la cathode de la diode, ne touchant pas le bord de la région 17.

Une métallisation liée à une électrode d'anode A est en contact avec la région 15 et une métallisation liée à une électrode de cathode K est en contact avec la région 19.

La partie gauche de la figure 2 représente un transistor NPN vertical 21 comprenant :
- une portion 13b du même substrat que la portion 13a, séparée de la portion 13a par un mur 22 de type P,
- du côté de la face supérieure de la portion 13b, une région 23 de contact ohmique de collecteur fortement dopée de type N ne touchant pas le bord gauche de la portion 13b et le mur 22,
- du côté de la face inférieure de la portion 13b, une région de type P, correspondant au prolongement de la région 17, ne touchant pas le bord gauche de la portion 13b,
- dans la région 17, une région 24 d'émetteur de même type et de même dopage que la région 19, ne touchant pas le bord de la couche 17 et le bord droit de la partie gauche de la figure.

Une métallisation d'émetteur liée à l'électrode K est en contact avec la région 24 de type N. Une métallisation de collecteur liée à une électrode READ est en contact avec la portion de substrat 13b par l'intermédiaire de la région 23. Une couche isolante 25 permet d'éviter que la métallisation K soit en contact avec des parties du substrat 13a-13b et avec la couche 17 au niveau du transistor. Une couche isolante 27 permet d'éviter que les métallisations READ et A soit en contact avec des parties du substrat 13a-13b.

On a reporté sur la figure 2 le schéma électrique du composant 10. La diode de Shockley D1 correspond à un transistor bipolaire T1 de type PNP connecté à un transistor bipolaire T2 de type NPN. La base du transistor T1 est connectée au collecteur du transistor T2, et le collecteur du transistor T1 est connecté à la base du transistor T2. L'émetteur du transistor T1 correspond à la région 15 (anode), sa base correspond à la portion 13a et son collecteur correspond à la région 17. Le collecteur du transistor T2 correspond à la portion 13a, sa base correspond à la région 17 et son émetteur correspond à la région 19 (cathode).

Un transistor T2' correspond au transistor 21. La base du transistor T2' est connectée à la base du transistor T2. Le collecteur du transistor T2' correspond à la portion de substrat 13b, sa base correspond à la région 17 et son émetteur correspond à la région 24.

Etant donné que les collecteurs, les bases et les émetteurs des transistors T2 et T2' sont respectivement de même type et de même dopage et que leurs bases et leurs émetteurs sont communs ou interconnectés, les transistors T2 et T2' forment un miroir de courant.

La figure 3 est une vue de dessus du composant 10 représenté en vue en coupe en figure 2. Le transistor 21 est situé dans le coin en haut à gauche de la diode de Shockley D1. La surface du transistor T2' est plus petite que la surface de la diode D1. Le rapport entre la surface de collecteur du transistor T2' et la surface de collecteur du transistor T2 est notée k, k étant un nombre supérieur à 1. Comme les transistors T2 et T2' sont montés en miroir de courant, le courant de collecteur du transistor T2' sera k fois plus faible que le courant de collecteur du transistor T2.

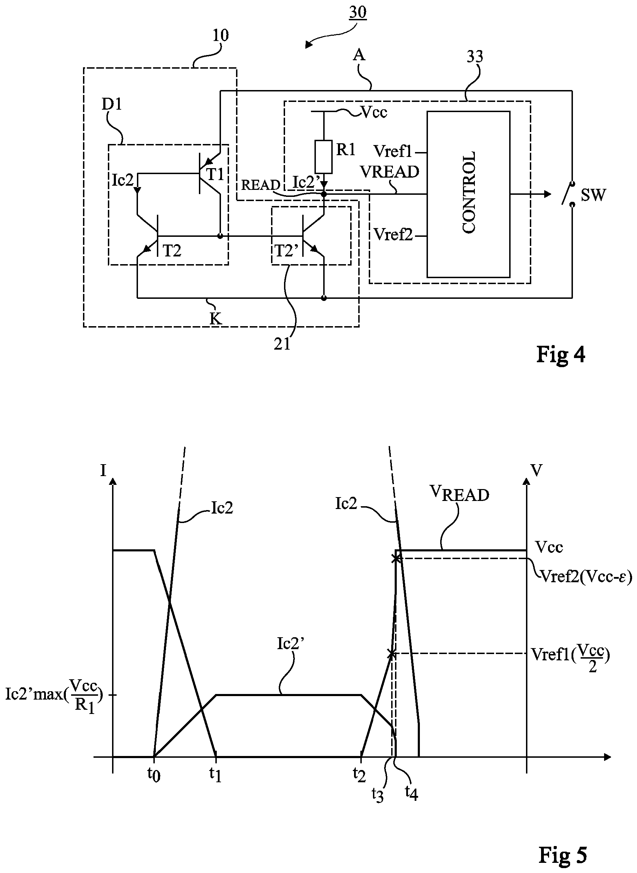

La figure 4 est un schéma électrique d'un dispositif de protection 30 comprenant le composant 10, un circuit de détection et de commande 33 et un commutateur SW. Les électrodes A et K du composant 10 sont connectées à une ligne d'alimentation, comme en figure 1. Le circuit de détection et de commande 33 comprend une résistance R1 connectant une source de tension VCC à l'électrode READ du composant 10, et un circuit de commande CONTROL connecté d'une part à l'électrode READ et d'autre part à la commande du commutateur SW.

La figure 5 est un chronogramme représentant le courant de collecteur Ic2' du transistor T2', le courant de collecteur Ic2 du transistor T2, et la tension VREAD entre les électrodes READ et K pendant une surtension.

Le fonctionnement du dispositif de protection 30 est le suivant.

En l'absence de surtension, la diode de Shockley D1 est non-passante et les transistors T1, T2 et T2' sont non passants. La tension VREAD est égale à VCC. Quand une surtension apparaît, à un instant t0, la diode de Shockley D1 devient passante, le courant qui la traverse passant par le transistor T2.

Le courant de collecteur Ic2' du transistor T2' est k fois plus faible que le courant de collecteur Ic2 du transistor T2. De plus, du fait de la présence de la résistance R1, ce courant Ic2' est écrêté à une valeur Ic2'max = VCC/R1.

A partir de l'instant t0, le courant Ic2 traversant la diode de Shockley D1 augmente rapidement et la tension VREAD diminue rapidement.

L'instant t1 correspond au moment où le courant Ic2 devient supérieur à une valeur k*Ic2'max. A partir de ce moment, le courant Ic2' est égal à la valeur Ic2'max et la tension VREAD est égale à zéro.

L'instant t2 correspond au moment où le courant Ic2 devient inférieur à la valeur d'écrêtage k*Ic2'max. A partir de ce moment, la tension VREAD croît et est déterminée par la relation VREAD = VCC-R1*Ic2'.

L'instant t3 correspond au moment où le circuit CONTROL détecte que la tension VREAD devient supérieure à un premier seuil de tension Vref1, ce qui signifie que le courant dans la diode de Shockley D1 est devenu inférieur à une valeur choisie. Le seuil Vref1 est par exemple choisi égal à VCC/2. Le circuit CONTROL ferme alors le commutateur SW après avoir vérifié que la tension VREAD est passée par une valeur sensiblement nulle. Du fait de la fermeture du commutateur SW, le courant traversant la diode de Shockley D1 et donc le courant Ic2' diminuent fortement. Il en résulte que la tension VREAD augmente fortement.

L'instant t4 correspond au moment où le circuit CONTROL détecte que la tension VREAD devient supérieure à un deuxième seuil de tension Vref2. Ce deuxième seuil est choisi pour traduire le fait que le courant dans la diode de Shockley D1 est devenu inférieur au courant de maintien Ih de la diode de Shockley D1. Le circuit CONTROL ouvre alors le commutateur SW et la diode de Shockley D1 est rebloquée.

Ainsi, le commutateur SW est commandé à l'ouverture et à la fermeture en fonction du courant réel traversant la diode de Shockley D1 et non en fonction de la tension aux bornes de l'ensemble de la diode de Shockley D1 et du commutateur SW.

Un avantage de commander le commutateur SW à la fermeture en fonction du courant réel traversant la diode de Shockley D1 est qu'on peut fermer le commutateur SW à une valeur de courant choisie en tenant compte de la présence possible susmentionnée d'un pic secondaire de courant en fin de surtension.

Un autre avantage de commander le commutateur SW à l'ouverture en fonction du courant réel traversant la diode de Shockley D1 est que le courant n'est pas affecté par les oscillations hautes fréquences (liées à la commutation d'inductances parasites) comme peut l'être la tension V_{AK} aux bornes de la diode de Shockley et du commutateur SW à la fermeture du commutateur SW. Ainsi, le circuit CONTROL ouvre le commutateur SW alors que le courant dans la diode de Shockley est effectivement inférieur au courant de maintien Ih.

En pratique, la valeur du courant auquel on souhaite fermer le commutateur SW est beaucoup plus grande (par exemple 50 fois plus grande) que la valeur Ih. Ainsi, le seuil de tension Vref1 auquel on choisit de fermer le commutateur SW est généralement beaucoup plus petit que le seuil de tension Vref2 auquel il convient de réouvrir le commutateur SW.

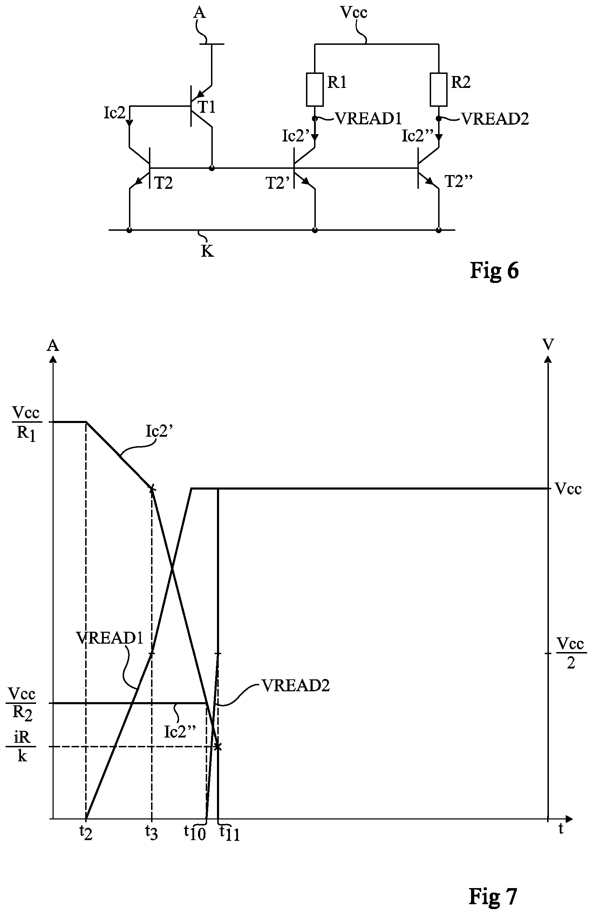

A titre d'exemple, si on choisit le premier seuil Vref1 égal à VCC/2, le seuil de tension Vref2 est très proche de la tension VCC, égal à VCC - ε, avec ε très proche de 0. Il est donc difficile de distinguer le seuil Vref2 de la tension VCC et le circuit CONTROL risque d'ouvrir le commutateur SW alors que le courant dans la diode de Shockley D1 est encore supérieur au courant de maintien Ih. La diode de Shockley D1 reste alors passante. Pour éviter cet inconvénient, on pourra adopter la variante décrite en relation avec les figures 6 et 7.

La figure 6 est un schéma électrique d'une variante de réalisation du composant 10 décrit en relation avec les figures 2 et 3. Au lieu d'intégrer un seul transistor de lecture T2' à une diode de Shockley D1 comme en figure 2, on intègre deux transistors de lecture T2' et T2". Il est ainsi possible d'obtenir de fortes sensibilités de détection pour des valeurs de courants très différentes, par exemple un courant de l'ordre de plus de 50 A pour la fermeture du commutateur SW et un courant de moins de 1 A pour son ouverture.

Dans un mode de réalisation, les collecteurs des transistors T2' et T2" ont les mêmes surfaces, k fois plus petites que la surface de la diode, et sont connectés à la source de tension VCC par l'intermédiaire de résistances R1 et R2 distinctes. La valeur de la résistance R1 est inférieure à la valeur de la résistance R2.

La figure 7 est un chronogramme représentant le courant de collecteur Ic2' du transistor T2', le courant de collecteur Ic2" du transistor T2", la tension VREAD1 de collecteur du transistor T2', et la tension VREAD2 de collecteur du transistor T2". Le commutateur SW est commandé à la fermeture en fonction de la tension VREAD1 et est commandé à l'ouverture en fonction de la tension VREAD2.

Le commutateur SW est fermé comme précédemment à un instant t3 lorsque le courant de collecteur Ic2' du transistor T2' devient inférieur à une valeur choisie (par exemple 1/k fois 50 A). Le commutateur SW est ouvert quand le courant de collecteur Ic2" du transistor T2" devient inférieur à 1/k fois Ih (par exemple 1/k fois 1A).

Avant l'instant t10, le courant Ic2" est écrêté à une valeur VCC/R2 nettement inférieure à la valeur VCC/R1 à laquelle était écrêté le courant Ic2'. On choisit par exemple d'écrêter le courant Ic2" à la valeur 2*Ih, au facteur 1/k près. De cette manière, la tension VREAD2 est égale au seuil de tension Vref2 égal à VCC/2 lorsque le courant Ic2" est égal à 1/k fois Ih.

A l'instant t10, le courant Ic2" devient inférieur à la valeur VCC/R2. A partir de cet instant, la tension VREAD2 augmente tandis que le courant Ic2" décroit.

A l'instant t11, la tension VREAD2 devient inférieure au seuil de tension Vref2 car le courant Ic2" devient inférieur à 1/k fois Ih. Le commutateur SW est alors commandé à l'ouverture et la diode est rebloquée.

Ainsi, le seuil Vref2 peut, comme le seuil Vref1, être éloigné de la tension VCC. Le commutateur SW est donc commandé à la fermeture comme à l'ouverture sans risque d'erreur. De plus, les seuils Vref1 et Vref2 peuvent être égaux, ce qui permet de ne générer qu'une seule tension de référence.

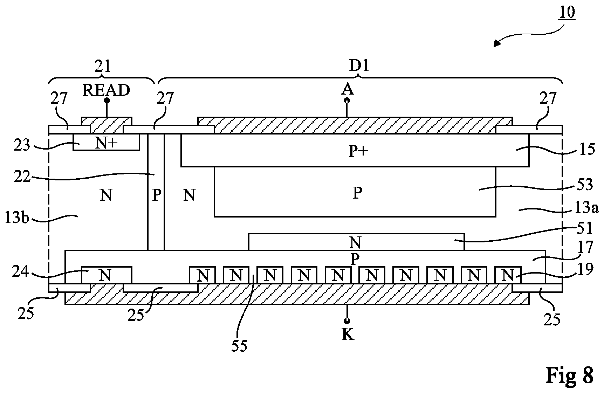

La figure 8 est une vue en coupe d'un exemple de réalisation pratique du composant 10 illustré de façon simplifiée en figures 2 et 3. Dans la figure 8, la diode de Shockley D1 comprend comme précédemment un substrat 13a de type N, une couche supérieure 15 de type P, et une région inférieure 17 de type P dans laquelle est formée une région 19 de type N. Elle comprend en outre, une région 51 de type N en contact avec la face supérieure de la région 17, et une région 53 de type P en contact avec la face inférieure de la région 15. Les régions 51 et 53 ne se rejoignent pas. De plus, la région 19 est munie de trous de court-circuit d'émetteur 55.

Le choix des niveaux de dopage des régions 51 et 53, et la densité des trous de court-circuit permet d'ajuster la tension de claquage VBR de la diode de Shockley D1 et sa tenue en tension.

En pratique, la région 53 est réalisée par diffusion profonde tout comme le mur 22. On profite donc de l'étape de fabrication de la région 53 pour fabriquer le mur 22.

Des modes de réalisation particuliers ont été décrits. Diverses variantes et modifications apparaîtront à l'homme de l'art. En particulier, tous les types de conductivité mentionnés ci-dessus peuvent être inversés. Ainsi toutes les régions de type P peuvent être de type N et toutes les régions de type N peuvent être de type P.

On a décrit un composant dans lequel la condition d'écrêtage du courant dans le transistor T2' est fixée par une résistance R1, et la condition d'écrêtage du courant dans le transistor T2" est fixée par une résistance R2, les collecteurs des transistors T2' et T2" ayant les mêmes surfaces. A titre de variante, on pourrait prévoir que les conditions d'écrêtage des courants dans les transistors T2' et T2" sont aussi fixées par les surfaces relatives des transistors T2' et T2".

De plus, on a décrit le mur 22 comme étant une région semiconductrice de type P. Le mur 22 pourrait aussi correspondre à une tranchée isolante s'étendant de la surface supérieure de la structure jusqu'à la région 17 de type P.

Par ailleurs, on a décrit la prévision de résistances R1 et éventuellement R2 externes au composant intégré. L'homme de l'art pourra prévoir une intégration de cette ou de ces résistances.

Le commutateur SW peut par exemple être un transistor MOS ou un transistor bipolaire à grille isolée (IGBT).

## Revendications

1. Composant (10) comportant :
une diode de Shockley verticale (D1) comprenant du haut vers le bas :
- une première région (15) d'un premier type de conductivité,
- un substrat (13a) d'un second type de conductivité,
- une deuxième région (17) du premier type de conductivité dans laquelle est formée une troisième région (19) du second type de conductivité,
le composant comprenant :
- une première métallisation en contact avec la première région et liée à une électrode d'anode (A),
- une deuxième métallisation en contact avec la troisième région et liée à une électrode de cathode (K),
ce composant comportant en outre un premier transistor vertical (T2'), ce transistor comprenant du haut vers le bas :
- une portion (13b) dudit substrat séparée de la diode de Shockley (D1) par un mur vertical (22),
- une portion de la deuxième région (17),
- une quatrième région (24) de même type et de même dopage que la troisième région (19), formée dans ladite portion de la deuxième région (17), la troisième région (19) étant connectée à la quatrième région (24), et
le composant comprenant :
- une troisième métallisation liée à l'électrode de cathode étant en contact avec la quatrième région et les métallisations n'étant en contact ni avec le substrat ni avec la deuxième région ; et
- une quatrième métallisation liée à une troisième électrode (READ) en contact avec ladite portion (13b) dudit substrat (13a) par l'intermédiaire d'une région fortement dopée du second type de conductivité.

2. Composant selon la revendication 1, comportant en outre un deuxième transistor (T2") de même structure que le premier transistor (T2').

3. Composant selon la revendication 1, dans lequel le premier transistor (T2') est situé dans un coin de la puce contenant la diode de Shockley (D1).

4. Système de protection (30) comportant :
un composant selon la revendication 1 ;
un commutateur (SW) connecté en parallèle de la diode de Shockley (D1) ;
une résistance (R1) dont une première borne est connectée à la borne principale du premier transistor correspondant à la troisième électrode ; et
une source de tension (VCC) connectée à la deuxième borne de ladite résistance (R1),
la borne principale supérieure du premier transistor étant connectée à un circuit de détection et de commande du commutateur (SW).

5. Système selon la revendication 4, dans lequel le commutateur (SW) est commandé à la fermeture et à l'ouverture en fonction de la tension (VREAD) entre la borne principale supérieure du premier transistor et la troisième région (19).

6. Système de protection selon la revendication 4 comportant en outre :
un deuxième transistor (T2") de même structure que le premier transistor (T2') ; et
une deuxième résistance (R2) dont une première borne est connectée à la borne principale supérieure du deuxième transistor, et dont la deuxième borne est connectée à la source de tension (VCC),
la borne principale supérieure du deuxième transistor étant connectée au circuit de détection et de commande du commutateur (SW).

7. Système selon la revendication 6, dans lequel le commutateur (SW) est commandé à la fermeture en fonction de la première tension (VREAD1) entre la borne principale supérieure du premier transistor et la troisième région (19), et le commutateur (SW) est commandé à l'ouverture en fonction de la deuxième tension (VREAD2) entre la borne principale supérieure du deuxième transistor et la troisième région (19).

## Patentansprüche

1. Ein Bauelement (10), das Folgendes aufweist:
eine vertikale Shockley-Diode (D1), die von oben nach unten Folgendes umfasst:
- einen ersten Bereich (15) eines ersten Leitfähigkeitstyps,
- ein Substrat (13a) eines zweiten Leitfähigkeitstyps,
- einen zweiten Bereich (17) des ersten Leitfähigkeitstyps, in dem ein dritter Bereich (19) des zweiten Leitfähigkeitstyps ausgebildet ist,
wobei das Bauelement Folgendes aufweist:
- eine erste Metallisierung, die mit dem ersten Bereich in Kontakt steht und mit einer Anodenelektrode (A) verbunden ist,
- eine zweite Metallisierung, die mit dem dritten Bereich in Kontakt steht und mit einer Kathodenelektrode (K) verbunden ist,
wobei das Bauelement ferner einen ersten vertikalen Transistor (T2') aufweist, wobei der Transistor von oben nach unten Folgendes umfasst:
- einen Teil (13b) des Substrats, der von der Shockley-Diode (D1) durch eine vertikale Wand (22) getrennt ist,
- einen Teil des zweiten Bereichs (17),
- einen vierten Bereich (24) desselben Typs und mit derselben Dotierung wie der dritte Bereich (19), der in dem Teil des zweiten Bereichs (17) gebildet ist, wobei der dritte Bereich (19) mit dem vierten Bereich (24) verbunden ist, und
wobei das Bauelement Folgendes aufweist:
- eine dritte Metallisierung, die mit der Kathodenelektrode verbunden ist und mit dem vierten Bereich in Kontakt steht, wobei die Metallisierungen weder mit dem Substrat noch mit dem zweiten Bereich in Kontakt stehen;
- eine vierte Metallisierung, die mit einer dritten Elektrode (READ) verbunden ist und die über einen hochdotierten Bereich des zweiten Leitfähigkeitstyps in Kontakt mit dem Teil (13b) des Substrats (13a) steht.

2. Bauelement nach Anspruch 1, das ferner einen zweiten Transistor (T2") mit derselben Struktur wie der erste Transistor (T2') aufweist.

3. Bauelement nach Anspruch 1, wobei der erste Transistor (T2') in einer Ecke des Chips angeordnet ist, der die Shockley-Diode (D1) enthält.

4. Schutzsystem (30), das Folgendes aufweist:
ein Bauelement nach Anspruch 1;
einen Schalter (SW), der parallel zu der Shockley-Diode (D1) geschaltet ist;
einen Widerstand (R1), der einen ersten Anschluss hat, der mit dem Hauptanschluss des ersten Transistors verbunden ist, der der dritten Elektrode entspricht; und
eine Spannungsquelle (VCC), die mit dem zweiten Anschluss des Widerstands (R1) verbunden ist,
wobei der obere Hauptanschluss des ersten Transistors mit einer Schaltung zur Erfassung und Steuerung des Schalters (SW) verbunden ist.

5. System nach Anspruch 4, wobei der Schalter (SW) so gesteuert wird, dass er in Abhängigkeit von der Spannung (VREAD) zwischen dem oberen Hauptanschluss des ersten Transistors und dem dritten Bereich (19) ein- und ausgeschaltet wird.

6. Das Schutzsystem nach Anspruch 4, das weiterhin Folgendes aufweist:
einen zweiten Transistor (T2") mit der gleichen Struktur wie der erste Transistor (T2'); und
einen zweiten Widerstand (R2), dessen erster Anschluss mit dem oberen Hauptanschluss des zweiten Transistors verbunden ist, und dessen zweiter Anschluss mit der Spannungsquelle (VCC) verbunden ist,
wobei der obere Hauptanschluss des zweiten Transistors mit einer Schaltung zur Erfassung und Steuerung des Schalters (SW) verbunden ist.

7. System nach Anspruch 6, wobei der Schalter (SW) gesteuert wird, um in Abhängigkeit von der ersten Spannung (VREAD1) zwischen dem oberen Hauptanschluss des ersten Transistors und dem dritten Bereich (19) eingeschaltet zu werden, und wobei der Schalter (SW) gesteuert wird, um in Abhängigkeit von der zweiten Spannung (VREAD2) zwischen dem oberen Hauptanschluss des zweiten Transistors und dem dritten Bereich (19) ausgeschaltet zu werden.

## Claims

1. A component (10) comprising:
a vertical Shockley diode (D1) comprising from top to bottom:
- a first region (15) of a first conductivity type,
- a substrate (13a) of a second conductivity type,
- a second region (17) of the first conductivity type having a third region (19) of the second conductivity type formed therein, the component comprising:
- a first metallization in contact with the first region and linked to an anode electrode (A),
- a second metallization in contact with the third region and linked to a cathode electrode (K),
this component further comprising a first vertical transistor (T2'), this transistor comprising from top to bottom:
- a portion (13b) of said substrate separated from the Shockley diode (D1) by a vertical wall (22),
- a portion of the second region (17),
- a fourth region (24) of same nature as the third region (19), formed in said portion of the second region (17), the third region (19) being connected to the fourth region (24), and
the component comprising:
- a third metallization linked to the cathode electrode and in contact with the fourth region, the metallizations being in contact neither with the substrate nor with the second region;
- a fourth metallization linked to a third electrode (READ) in contact with said portion (13b) of said substrate (13a) via a highly doped region of the second conductivity type.

2. The component of claim 1, further comprising a second transistor (T2") of same structure as the first transistor (T2').

3. The component of claim 1, wherein the first transistor (T2') is located in a corner of the chip containing the Shockley diode (D1).

4. A protection system (30) comprising:
the component of claim 1;
a switch (SW) connected in parallel with the Shockley diode (D1);
a resistor (R1) having a first terminal connected to the upper main terminal of the first transistor corresponding to the third electrode; and
a voltage source (VCC) connected to the second terminal of said resistor (R1),
the upper main terminal of the first transistor being connected to a circuit of detection and control of the switch (SW) .

5. The system of claim 4, wherein the switch (SW) is controlled to turn on and off according to the voltage (VREAD) between the upper main region of the first transistor and the third region (19).

6. The protection system of claim 4, further comprising:
a second transistor (T2") of same structure as the first transistor (T2'); and
a second resistor (R2) having a first terminal connected to the upper main terminal of the second transistor, and having its second terminal connected to the voltage source (VCC),
the upper main terminal of the second transistor being connected to a circuit of detection and control of the switch (SW).

7. The system of claim 6, wherein the switch (SW) is controlled to turn on according to the first voltage (VREAD1) between the upper main terminal of the first transistor and the third region (19), and the switch (SW) is controlled to turn off according to the second voltage (VREAD2) between the upper main terminal of the second transistor and the third region (19).
